# EUROPEAN PATENT APPLICATION

(11) **EP 3 136 453 A1**
(43) Date of publication of application: **01.03.2017**
(21) Application number: 15782700.7
(22) Date of filing: 02.04.2015
(51) Int. Cl.: H01L 33/50, C04B 35/50, C04B 35/622, C04B 41/87

(54) **WAVELENGTH CONVERSION MEMBER AND METHOD FOR PRODUCING SAME**

(30) Priority: 23.04.2014 JP 2014089577; 27.02.2015 JP 2015039039
(71) Applicant: Nitto Denko Corporation, Ibaraki-shi, Osaka 567-8680 (JP)
(72) Inventor: FUJII, Hironaka, Ibaraki-shi Osaka 567-8680 (JP); SHIRAKAWA, Masahiro, Ibaraki-shi Osaka 567-8680 (JP)
(74) Representative: Hoffmann Eitle
(86) International application number: PCT/JP2015/060518
(87) International publication number: WO 2015/163110

(57) **Abstract**

A method for producing a wavelength conversion member includes preparing an element-disposed substrate including a substrate, a plurality of phosphor ceramic elements disposed on the substrate in spaced-apart relation in a direction perpendicular to the thickness direction of the substrate; embedding the plurality of phosphor ceramic elements in a curable layer containing the inorganic substance; producing a cover layer by curing the curable layer; and cutting the cover layer and the substrate in the thickness direction so as to include at least one of the phosphor ceramic elements.

## Description

### TECHNICAL FIELD

The present invention relates to a wavelength conversion member and a production method thereof; in particular, the present invention relates to a method for producing a wavelength conversion member, and a wavelength conversion member produced by the method.

### BACKGROUND ART

A light-emitting diode device generally includes an LED (light-emitting diode element) that is mounted on the surface of a substrate and emits blue light, a phosphor layer that can convert the blue light to yellow light and is provided on the LED, and an encapsulating layer that encapsulates the LED. Such a light-emitting diode device emits white light by color mixture of blue light emitted from the LED encapsulated by the encapsulating layer and penetrating the phosphor layer, and yellow light produced by converting the wavelength of a portion of the blue light at the phosphor layer

Patent Document 1 (ref: below) has proposed, as a method for producing such a light-emitting diode device, the following method

That is, first, a recess portion is provided in a transparent encapsulating layer, and a curable phosphor composition is introduced into the recess portion by potting and is cured to produce a wavelength conversion sheet including the transparent encapsulating layer and a phosphor layer, and then an LED is embedded in the surface of the phosphor layer of the wavelength conversion sheet.

### Citation List

### Patent Document

Patent Document 1Japanese Unexamined Patent Publication No. 2013-187227

### [SUMMARY OF THE INVENTION]

### PROBLEM TO BE SOLVED BY THE INVENTION

However, in semiconductor light-emitting devices such as light-emitting diode devices and semiconductor laser devices, a high power (high output) light source is sometimes provided. When the wavelength of such a high power light is converted with the wavelength conversion sheet, high heat resistance is required for the wavelength conversion sheet. Thus, use of phosphor ceramics with excellent heat resistance in a wavelength conversion sheet has been examined.

However, for phosphor ceramics, phosphor is sintered at a high temperature (e.g., 1000°C or more), and therefore there are disadvantages such as the following: unlike the above-described method of Patent Document 1, the formation cannot be done by potting the phosphor composition and curing.

An object of the present invention is to provide a method for producing a wavelength conversion member easily and industrially, and a wavelength conversion member produced by the method and having excellent heat resistance.

### MEANS FOR SOLVING THE PROBLEM

A method for producing a wavelength conversion member of the present invention includes a step of preparing an element-disposed substrate including a substrate, a plurality of phosphor ceramic elements disposed on the substrate in spaced-apart relation in a direction perpendicular to the thickness direction of the substrate; a step of embedding the plurality of phosphor ceramic elements in a curable layer containing the inorganic substance; a step of producing a cover layer by curing the curable layer; and a step of cutting the cover layer and the substrate in the thickness direction so as to include at least one of the phosphor ceramic elements.

In the method for producing a wavelength conversion member of the present invention, it is preferable that the curable layer is formed from a ceramic ink, or a curable resin composition containing a curable resin and at least one inorganic particle of inorganic oxide particles and metal particles.

In the method for producing a wavelength conversion member of the present invention, it is preferable that the substrate is an easy-release sheet.

A wavelength conversion member of the present invention is produced by the above-described production method.

### EFFECT OF THE INVENTION

The method for producing a wavelength conversion member of the present invention allows for easy and industrial production of a wavelength conversion member including a phosphor ceramic element and a cover layer covering the surface thereof.

The wavelength conversion member of the present invention produced by the production method of the present invention has excellent heat resistance.

### BRIEF DESCRIPTION OF THE DRAWINGS

FIG. 1A to FIG. 1E are process diagrams in cross section illustrating a method for producing the wavelength conversion member of the present invention in an embodiment,
FIG. 1A illustrating a step of preparing a green sheet,
FIG. 1B illustrating a step of baking the green sheet,
FIG. 1C illustrating a step of disposing a phosphor ceramic layer on a substrate,
FIG. 1D illustrating a step of scraping off a portion of the phosphor ceramic layer, and
FIG. 1E illustrating a step of producing an element-disposed substrate.
FIG. 2F to FIG. 2J are, following FIG. 1A to FIG. 1E, process diagrams in cross section illustrating a method for producing the wavelength conversion member of the present invention in an embodiment,

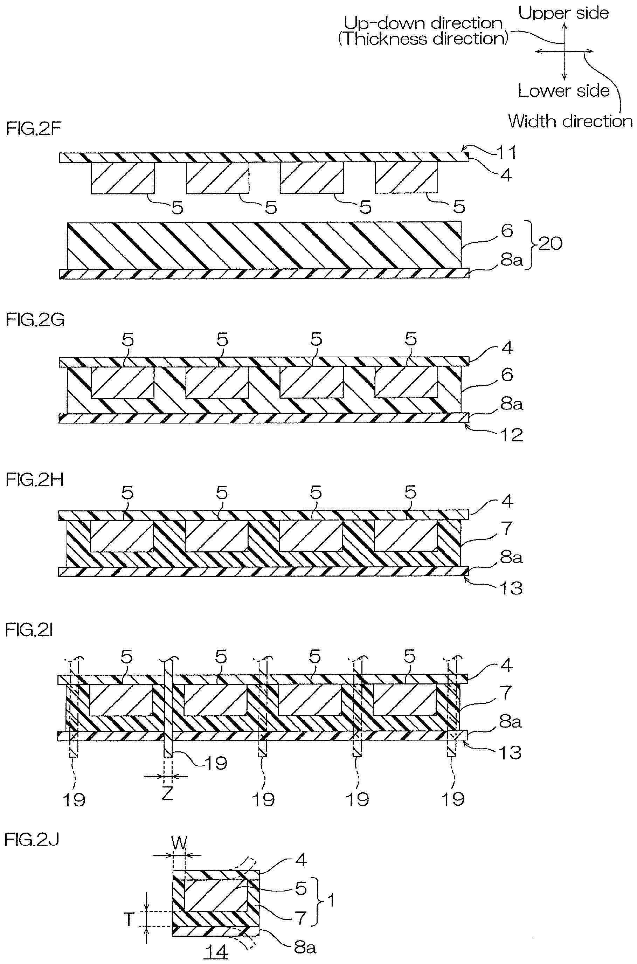

FIG. 2F illustrating a step of disposing an element-disposed substrate to face a curable layer,
FIG. 2G illustrating a step of embedding a phosphor ceramic element in the curable layer,
FIG. 2H illustrating a step of curing the curable layer,
FIG. 2I illustrating a step of cutting a cover layer and the substrate, and
FIG. 2J illustrating a step of producing the wavelength conversion member.

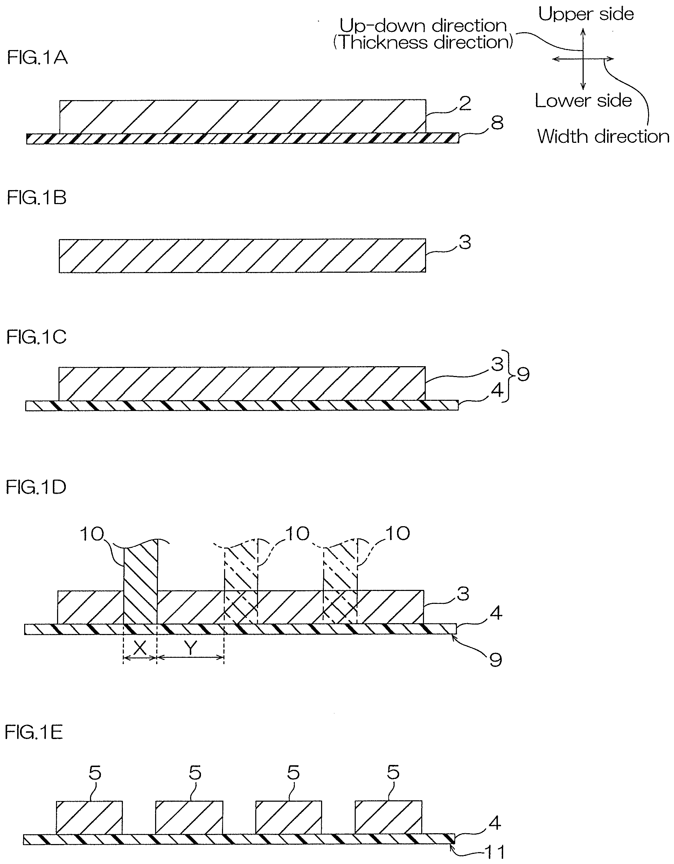

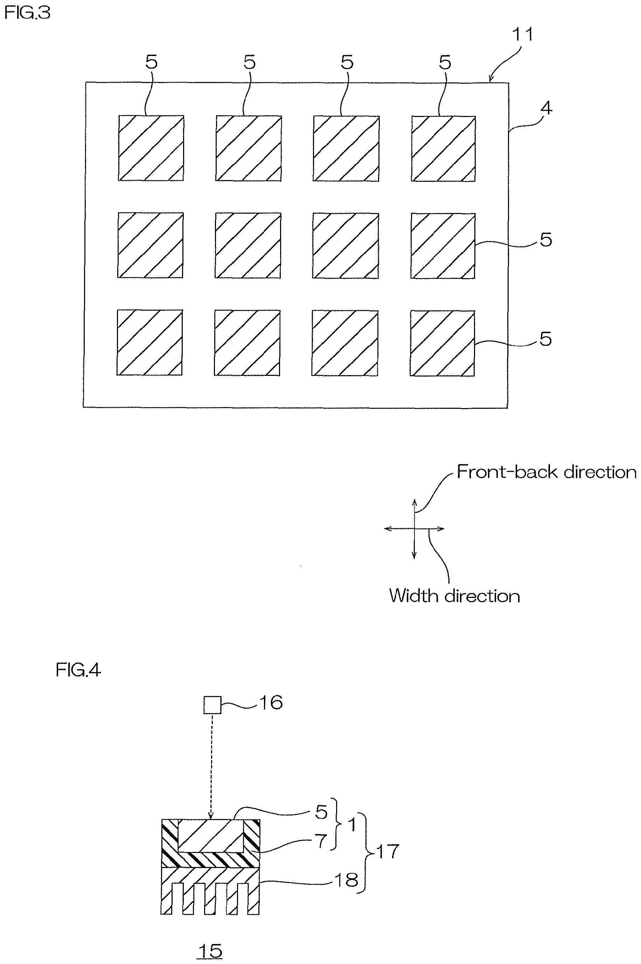

FIG. 3 shows a plan view in the step of FIG. 1E.
FIG. 4 shows a cross-sectional view of a wavelength conversion heat dissipation member including an embodiment of the wavelength conversion member of the present invention.

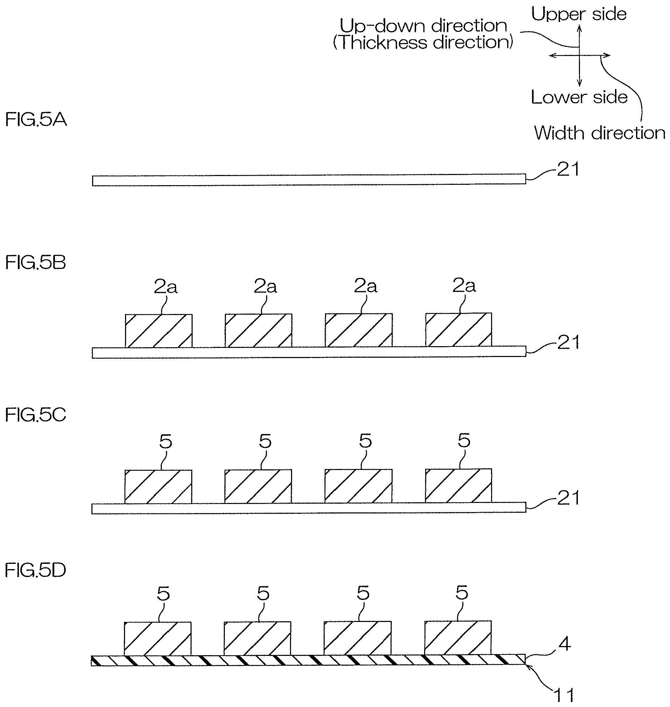

FIG. 5A to FIG. 5D are process diagrams in cross section illustrating a method for producing the wavelength conversion member of the present invention in another embodiment (embodiment in which the phosphor ceramic element has a circular shape when viewed from the top),
FIG. 5A illustrating a step of preparing a heat resistance substrate,
FIG. 5B illustrating a step of forming a green body,
FIG. 5C illustrating a step of baking the green body, and
FIG. 5D illustrating a step of redisposing the phosphor ceramic element.

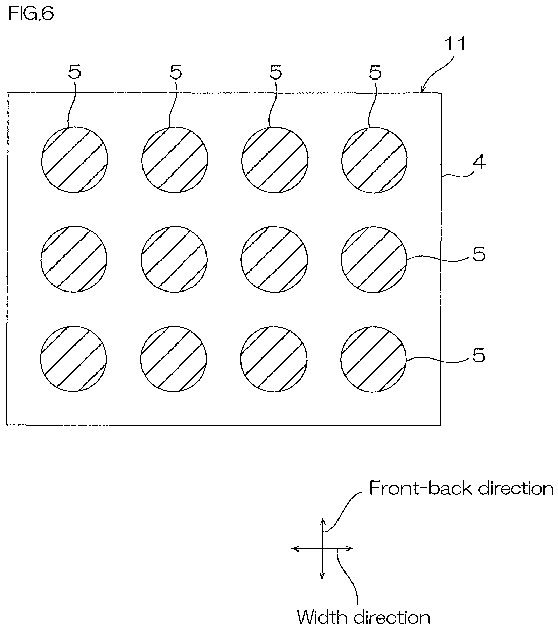

FIG. 6 shows a plan view in the step of FIG. 5D.

### [DESCRIPTION OF EMBODIMENTS]

A method for producing a wavelength conversion member 1 is described with reference to FIG. 1A to FIG. 2J.

The up-down direction on the plane of the sheet in FIG. 1A to FIG. 1E is referred to as "up-down direction" (first direction, thickness direction), the upper side on the plane of the sheet is upper side, and the lower side on the plane of the sheet is lower side. The left-right direction on the plane of the sheet in FIG. 1A to FIG. 1E is referred to as "width direction" (second direction, left-right direction, direction perpendicular to the first direction), the right direction on the plane of the sheet is right side, and the left direction on the plane of the sheet in FIG. 1A to FIG. 1E is left side. The paper thickness direction in FIG. 1A to FIG. 1E is referred to as "front-back direction" (third direction, direction perpendicular to the first direction and the second direction), the near side in the paper thickness direction in FIG. 1A to FIG. 1E is front side, and the far side in the paper thickness direction in FIG. 1A to FIG. 1E is back side. The directions in FIG. 1A to FIG. 1E are based on in Figures other than FIG. 1A to FIG. 1E as well.

The method for producing a wavelength conversion member 1 includes preparing a green sheet 2, baking the green sheet 2, disposing a phosphor ceramic layer 3 on a substrate 4, scraping off a portion of the phosphor ceramic layer 3, producing an element-disposed substrate 11 in which a phosphor ceramic element 5 is disposed, disposing the element-disposed substrate 11 to face a curable layer 6, embedding the phosphor ceramic element 5 in the curable layer 6, curing the curable layer 6, cutting a cover layer 7 and the substrate 4, and producing a wavelength conversion member 1.

First, as shown in FIG. 1A, a green sheet 2 is prepared (preparation step). The green sheet 2 is formed by applying and drying a slurry containing, for example, a phosphor material, a binder resin, and a solvent on the upper face of a release sheet 8.

The phosphor material is a raw material composing the phosphor described later, and is prepared by suitably selecting from examples thereof including, for example, aluminum oxide, yttrium oxide, cerium oxide, zirconium oxide, titanium oxide, and furthermore, those materials added with other elements for activation.

For the binder resin, a known binder resin used for production of the green sheet 2 can be used, and examples thereof include acrylic polymer, butyral polymer, vinyl polymer, and urethane polymer. Preferably, acrylic polymer is used.

The binder resin content relative to a total volume amount of the phosphor material and binder resin is, for example, 5% by volume or more, preferably 20% by volume or more, and 80% by volume or less, preferably 60% by volume or less.

Examples of the solvent include water, and organic solvents such as acetone, methyl ethyl ketone, methanol, ethanol, toluene, methyl propionate, and methylcellsolve.

The solvent content in the slurry is, for example, 1 to 30 mass%.

For the slurry, as necessary, known additives such as a dispersing agent, a plasticizer, and a sintering auxiliary agent can be added.

Then, the above-described components are blended at the above-described ratio, and the mixture is subjected to wet blending with a ball mill, thereby preparing a slurry.

Then, the slurry is applied on the upper face of the release sheet 8 by known application methods such as doctor blade, gravure coater, fountain coater, cast coater, spin coater, and roll coater, and dried, thereby forming the green sheet 2.

Examples of the release sheet 8 include resin films such as polyester films including a polyethylene terephthalate (PET) film; a polycarbonate film; polyolefin films including a polyethylene film and a polypropylene film; a polystyrene film; an acrylic film; a silicone resin film; and a fluorine resin film. Furthermore, metal foils such as copper foil and stainless steel foil can be used. Preferably, a resin film, even more preferably, a polyester film is used.

The surface of the release sheet 8 is subjected to, as necessary, release treatment to improve release properties.

The release sheet 8 has a thickness of, for example, 10 to 200 µm, in view of handleability and costs.

The thus produced green sheet 2 is ceramics before sintering of the phosphor ceramic layer 3 (phosphor ceramic plate), and is formed into a generally rectangular flat plate shape when viewed from the top.

The green sheet 2 can also be formed by laminating a plurality of (a plurality of layers) green sheets 2 by heat lamination to obtain a desired thickness.

The green sheet 2 has a thickness of, for example, 10 µm or more, preferably 30 µm or more, and for example, 500 µm or less, preferably 200 µm or less.

Then, as shown in FIG. 1B, the green sheet 2 is baked (baking step).

The baking temperature is, for example, 1300°C or more, preferably 1500°C or more, and for example, 2000°C or less, preferably 1800°C or less.

The baking time is, for example, 1 hour or more, preferably 2 hours or more, and for example, 24 hours or less, preferably 5 hours or less.

The baking can be performed under normal pressure, under reduced pressure, or under vacuum. Preferably, the baking can be performed under reduced pressure or vacuum.

Before the above-described baking (main baking), to thermally decompose and remove the organic component such as a binder resin and a dispersing agent, de-binder processing can be performed by using an electric furnace in air by preheating at, for example, 600 to 1300°C.

The speed of temperature increase in baking is, for example, 0.5 to 20°C/min.

The phosphor ceramic layer 3 is produced in this manner.

The thus produced phosphor ceramic layer 3 is formed into a generally rectangular flat plate shape when viewed from the top.

The phosphor ceramic layer 3 has a thickness of, for example, 10 µm or more, preferably 50 µm or more, and for example, 500 µm or less, preferably 200 µm or less.

Then, as shown in FIG. 1C, the phosphor ceramic layer 3 is disposed on the substrate 4 (substrate disposing step). To be specific, the phosphor ceramic layer 3 is disposed on a generally center portion of the upper face of the substrate 4.

For the substrate 4, in view of scraping off of the blade (described later), and removal of the substrate 4 from the wavelength conversion member 1, preferably, an easy-release sheet is used. The easy-release sheet is formed, for example, by a thermal release sheet that can be released easily by heat.

The thermal release sheet includes a support layer, and a pressure-sensitive adhesive layer laminated on the upper face of the support layer.

The support layer is formed, for example, from a heat resistance resin such as polyester.

The pressure-sensitive adhesive layer has tackiness at, for example, normal temperature (25°C), and is formed from a thermal expansion adhesive whose tackiness decreases when heated (or loses adhesiveness).

For the thermal release sheet, a commercially available product can be used, and to be specific, REVALPHA series (registered trademark, manufactured by Nitto Denko Corporation) may be used.

The thermal release sheet is released from the wavelength conversion member 1, based on reduction of tackiness of the pressure-sensitive adhesive layer by heat, while reliably supporting, by the support layer, the phosphor ceramic layer 3 (and the wavelength conversion member 1) through the pressure-sensitive adhesive layer.

The substrate 4 can be formed from resin materials including vinyl polymers such as polyolefin (to be specific, polyethylene, polypropylene) and ethylene-vinyl acetate copolymer (EVA); polyesters such as polyethylene terephthalate and polycarbonate; and fluorine resin such as polytetrafluoroethylene. The substrate can be formed from, for example, metal materials such as iron, aluminum, and stainless steel.

The substrate 4 has a thickness of, for example, 10 to 1000 µm.

The ceramic laminate 9 including the substrate 4 and the phosphor ceramic layer 3 provided on the upper face of the substrate 4 is produced in this manner.

Then, as shown in FIG. 1D, a portion of the phosphor ceramic layer 3 is removed (removal step). To be specific, a portion of the phosphor ceramic layer 3 is scraped off by using a blade such as dicing blade 10.

The dicing blade 10 is a disc rotary blade used for a known or commercially available dicing device. The distal end (lower end) of the dicing blade 10 is formed to be a generally rectangular shape (plate) extending in up-down direction when projected in the direction along the cutting direction (in FIG. 1D, paper thickness direction, i.e., front-back direction). That is, it is formed so that the cutting plane is a generally rectangular shape.

The dicing blade 10 has a width direction length X at the distal end of, for example, 0.05 mm or more, preferably 0.1 mm or more, and for example, 2.0 mm or less, preferably 1.0 mm or less.

In this step, first, as shown in FIG. 1D, a portion of the phosphor ceramic layer 3 is scraped off along the front-back directions.

To be specific, the ceramic laminate 9 is disposed inside the dicing device so that the cutting direction is front-back direction. Then, the positions of the dicing blade 10 or the ceramic laminate 9 are arranged so that when moving the dicing blade 10, the distal end (lower end) of the dicing blade 10 is in contact with the phosphor ceramic layer 3, and does not penetrate the substrate 4. That is, the position of the dicing blade 10 or the ceramic laminate 9 in up-down direction is adjusted so that the distal end of the dicing blade 10 reaches the upper face of the substrate 4, and does not reach the lower face of the substrate 4. Then, while rotating the dicing blade 10 at a high speed, the dicing blade 10 is moved in front-back direction along the cutting direction.

In this manner, the portion of the phosphor ceramic layer 3 contacting the dicing blade 10 (periphery of distal end) is scraped off from the substrate 4 along front-back direction. That is, the phosphor ceramic layer 3 is scraped off into a generally rectangular shape. At the portion scraped off, the upper face of the substrate 4 is exposed.

The scraping off in front-back direction is repeatedly performed, as shown in the phantom line in FIG. 1D, with a desired interval (that is, desired width direction length of the phosphor ceramic element 5).

Then, in the same manner as described above, while rotating the dicing blade 10 at a high speed, the dicing blade 10 is moved so that the cutting direction is along the width direction, thereby scraping off a portion of the phosphor ceramic layer 3 in the width direction. The scraping off in the width direction is repeatedly performed with a desired interval.

That is, as shown in FIG. 3, the phosphor ceramic layer 3 is scraped off like a grid.

In this manner, as shown in FIG. 1E and FIG. 3, an element-disposed substrate 11 including a substrate 4, and a plurality of phosphor ceramic elements 5 arranged in line like a grid on the upper face of the substrate 4 is produced.

In the above-described step, a portion of the phosphor ceramic layer 3 is scraped off by fixing the phosphor ceramic layer 3 and moving the dicing blade 10. However, for example, the position of the dicing blade 10 rotating at a high speed can be fixed, and by moving the ceramic laminate 9 relative to the dicing blade 10 with, for example, an X-Y stage, in front-back direction or width direction, a portion of the phosphor ceramic layer 3 can be scraped off.

The phosphor ceramic element 5 is formed into a generally rectangular shape when viewed in cross section and a generally rectangular shape when viewed from the top.

The width direction length Y of the phosphor ceramic element 5 is, for example, 0.2 mm or more, preferably 1 mm or more, and for example, 10 mm or less, preferably 5 mm or less. The front-back directions length of the phosphor ceramic element 5 is, for example, 0.05 mm or more, preferably 0.1 mm or more, and for example, 5 mm or less, preferably 3 mm or less.

The width direction interval and the front-back direction interval of the plurality of phosphor ceramic elements 5 are the same as the width direction length X of the distal end of the dicing blade 10.

Then, as shown in FIG. 2F, the element-disposed substrate 11 is disposed to face the curable layer 6 (disposing face to face step). To be specific, first, a curable layer sheet 20 on which the curable layer 6 is provided on the release sheet 8a is prepared. The curable layer sheet 20 is produced by applying a curable composition containing the inorganic substance on the upper face of the release sheet 8a by a known method.

For the curable composition, those containing an inorganic substance and is curable are used without limitation, and examples thereof include a ceramic ink, a curable resin composition containing a curable resin and inorganic particles, and an aqueous silicate solution containing alkali metal silicate and inorganic particles.

The ceramic ink contains, for example, inorganic ceramics, a binder such as organopolysiloxane, and a solvent, and is cured (solidified) at a low temperature (e.g., 120 to 180°C). Examples of the inorganic substance in the ceramic ink include white pigments such as silicon dioxide, titanium dioxide, and potassium titanate. Examples of the solvent include ethers such as butyldiglycolether and diethylene glycoldibutylether. In view of dispersiveness, white pigment is preferably subjected to surface treatment.

For the ceramic ink, a commercially available product can be used, and to be specific, examples thereof include ceramic inks manufactured by AIN Co., Ltd. (TYPE RG, TYPE AN, TYPE UV, and TYPE SD).

Examples of the curable resin contained in the curable resin composition include a curable silicone resin, an epoxy resin, and an acrylic resin. Preferably, a curable silicone resin is used.

Examples of the curable silicone resin include condensation reaction curable silicone resin, and addition reaction curable silicone resin. Preferably, an addition reaction curable silicone resin is used.

The addition reaction curable silicone resin is composed of a silicone resin composition containing, for example, an ethylene-based unsaturated hydrocarbon group-containing polysiloxane as a main component, and an organo hydrogen siloxane as a cross-linking agent. The addition reaction curable silicone resin is generally provided as two components of liquid A containing a main component (ethylene-based unsaturated hydrocarbon group-containing polysiloxane), and liquid B containing a cross-linking agent (organo hydrogen siloxane). Then, the main component (liquid A) and the cross-linking agent (liquid B) are mixed and a mixture is prepared, and in a step of forming the cover layer 7 from the mixture, the ethylene-based unsaturated hydrocarbon group-containing polysiloxane and the organo hydrogen siloxane undergo addition reaction by heat, curing the addition reaction curable silicone resin to form silicone elastomer (cured product).

For the addition reaction curable silicone resin, a commercially available product (trade name: KER-2500, manufactured by Shin-Etsu Chemical Co., Ltd., trade name: LR-7665, manufactured by Wacker asahikasei silicone co.,ltd., etc.) may be used.

Examples of the inorganic substance composing the inorganic particles include inorganic oxides such as silicon dioxide, titanium dioxide, aluminum oxide, zirconium oxide, and titanic acid composite oxide (e.g., barium titanate, potassium titanate), and metals such as silver and aluminum. In view of light reflectivity and heat-releasing characteristics, preferably, titanium dioxide, aluminum oxide, zirconium oxide, barium titanate, and silver are used, and in view of long-term heat resistance, more preferably, titanium dioxide, aluminum oxide, zirconium oxide, and barium titanate are used, even more preferably, titanium dioxide and aluminum oxide are used.

The inorganic particles have an average particle size (average maximum length) of, for example, 0.1 to 50 µm.

For the curable resin composition, preferably, a curable resin composition containing a curable silicone resin and inorganic particles composed of at least one selected from the group consisting of titanium dioxide, aluminum oxide, zirconium oxide, barium titanate, and silver; more preferably, a curable resin composition containing a curable silicone resin and inorganic particles composed of at least one selected from the group consisting of titanium oxide, aluminum oxide, zirconium oxide, and barium titanate; and even more preferably, a curable resin composition containing a curable silicone resin and inorganic particles composed of at least one of titanium oxide and aluminum oxide.

Examples of the alkali metal silicate included in the aqueous silicate solution include sodium silicate (water glass).

The curable composition has an inorganic substance content (solid content) of, for example, 30 mass% or more, preferably 40 mass% or more, more preferably 60 mass% or more, and for example, 90 mass% or less, preferably 80 mass% or less. The curable composition has a binder or curable resin content (solid content) of, for example, 10 mass% or more, preferably 20 mass% or more, for example, 70 mass% or less, preferably 60 mass% or less, more preferably 40 mass% or less.

For the curable composition, preferably used are a ceramic ink and a curable resin composition containing a curable resin and at least one inorganic particle of inorganic oxide particles and metal particles; more preferably used are a ceramic ink and a curable resin composition containing a curable resin and inorganic oxide particles; even more preferably used is a ceramic ink. In this manner, heat-releasing characteristics and reflectivity of the cover layer 7 can be improved.

The release sheet 8a is the same as the release sheet 8.

For the application method of the curable composition, a known application method such as printing and dispensing can be used.

The curable layer 6 has a thickness of, for example, 80 µm or more, preferably 90 µm or more, and for example, 1000 µm or less, preferably 500 µm or less.

Then, the element-disposed substrate 11 is disposed to face the curable layer sheet 20 in spaced-apart relation in the thickness direction so that the phosphor ceramic element 5 face the curable layer 6.

Then, as shown in FIG. 2G, the phosphor ceramic element 5 is embedded in the curable layer 6 (embedding step). To be specific, the element-disposed substrate 11 is moved to a lower side, and pressed against the curable layer sheet 20.

In this manner, the surface of the phosphor ceramic element 5 (lower face and side face) is covered with the curable layer 6. At the same time, the surface (lower face) of the substrate 4 exposed from the phosphor ceramic element 5 is covered with the curable layer 6.

The pressure is, for example, 0.03MPa or more, preferably 0.1MPa or more, and for example, 2MPa or less, preferably 0.5MPa or less.

A curable layer-element laminate 12 including the substrate 4, the plurality of phosphor ceramic elements 5 arranged in line below the substrate 4, the curable layer 6 formed below the substrate 4 so as to cover the lower face and the side face of the plurality of phosphor ceramic elements 5, and the release sheet 8a disposed below the curable layer 6 is produced in this manner.

The step of disposing the element-disposed substrate 11 to face the curable layer sheet 20, and the step of embedding the phosphor ceramic element 5 in the curable layer 6 can be continuously performed as one step.

Then, as shown in FIG. 2H, the curable layer 6 can be cured (curing step). To be specific, the curable layer-element laminate 12 is heated to cure (solidify) the curable layer 6.

The heating temperature is, for example, 100°C or more, preferably 120°C or more, and for example, 200°C or less, preferably 180°C or less.

The heating time is, for example, 0.5 hours or more, preferably 1 hour or more, and for example, 12 hours or less, preferably 6 hours or less.

Furthermore, as necessary, before thermosetting, drying step can be conducted under conditions of, for example, 50 to 100°C, and 1 to 10 hours.

In this manner, the curable layer 6 is heated and cured, thereby forming the cover layer 7.

That is, a cover layer-element laminate 13 including the substrate 4, the plurality of phosphor ceramic elements 5 arranged in line below the substrate 4, the cover layer 7 formed below the substrate 4 so as to cover the lower face and the side face of the plurality of phosphor ceramic elements 5, and the release sheet 8a disposed below the cover layer 7 is produced.

Then, as shown in FIG. 2I, the cover layer 7 and the substrate 4 are cut in the thickness direction so as to include one phosphor ceramic element 5 (cutting step). That is, the plurality of phosphor ceramic elements 5 are cut so that the phosphor ceramic elements 5 are separated into individual pieces (individualized).

To be specific, the substrate 4, the cover layer 7, and the release sheet 8a are cut by dicing between the phosphor ceramic elements 5 next to each other, along the thickness direction using a narrow-width blade 19.

The narrow-width blade 19 is a blade having a narrower width than that of the dicing blade 10, and is a disc rotary blade used for a known or commercially available dicing device. The narrow-width blade 19 is formed to be a generally rectangular shape (plate) extending in up-down direction when projected in the direction along the cutting direction (in FIG. 2I, paper thickness direction, i.e., front-back direction).

The narrow-width blade 19 has a width direction length Z that is smaller than the width direction length X of the dicing blade 10, and the width direction length Z is, for example, 80% or less of X, preferably 60% or less, and for example, 10% or more, preferably 30% or more. To be specific, for example, 0.01 mm or more, preferably 0.05 mm or more, and for example, 1.5 mm or less, preferably 0.8 mm or less.

In this cutting step, the cover layer-element laminate 13 is disposed in the dicing device. Then, positions of the narrow-width blade 19 or the cover layer-element laminate 13 are adjusted so as to cut the substrate 4, the cover layer 7, and the release sheet 8a in the thickness direction. That is, the position of the narrow-width blade 19 or the cover layer-element laminate 13 is adjusted in up-down direction so that the distal end of the narrow-width blade 19 penetrates the substrate 4 and the cover layer 7 and reaches the lower face of the release sheet 8a. Then, in the same manner as in the above-described removal step, while rotating the narrow-width blade 19 at a high speed, the narrow-width blade 19 is moved in front-back direction and width direction (that is, like a grid) between the phosphor ceramic elements 5 next to each other, thereby cutting the substrate 4, the cover layer 7, and the release sheet 8a.

As shown in FIG. 2J, the substrate-laminated wavelength conversion member 14 including the substrate 4, the individualized phosphor ceramic element 5, the cover layer 7, and the release sheet 8a is produced in this manner.

Then, as shown in the phantom line of FIG. 2J, the substrate 4 and the release sheet 8a are removed, thereby producing the wavelength conversion member 1 including the individualized phosphor ceramic element 5 and the cover layer 7.

The phosphor ceramic element 5 is provided at a generally center of the lower face of the substrate 4 when viewed from the top, and is formed from ceramics (baked product) of the phosphor.

The phosphor contained in the phosphor ceramics has a wavelength conversion function, and examples thereof include yellow phosphor which can convert blue light to yellow light, and red phosphor which can convert blue light to red light.

Examples of yellow phosphor include silicate phosphor such as (Ba,Sr,Ca)₂SiO₄;Eu and (Sr,Ba)₂SiO₄: Eu (barium orthosilicate (BOS)); garnet phosphor having a garnet crystal structure such as Y₃Al₅O₁₂: Ce (YAG (yttrium aluminum garnet): Ce) and Tb₃Al₃O₁₂: Ce (TAG (terbium·aluminum·garnet): Ce); and oxynitride phosphor such as Ca-α-SiAlON. Examples of the red phosphor include nitride phosphor such as CaAlSiN₃: Eu and CaSiN₂: Eu.

The cover layer 7 is provided on the lower face of the substrate 4 so as to cover the surface of the phosphor ceramic element 5. To be specific, the cover layer 7 is provided on the lower face of the substrate 4 so as to cover the surface of the phosphor ceramic element 5 (lower face and side face), and the lower face of the substrate 4 (excluding the surface where the phosphor ceramic element 5 is disposed).

The cover layer 7 has a thickness of (distance T from the lower face of the phosphor ceramic element 5 to the upper face of the release sheet 8a of FIG. 2J), for example, 10 µm or more, preferably 50 µm or more, and for example, 500 µm or less, preferably 200 µm or less.

The cover layer 7 has a side face width (distance W from the side face of the phosphor ceramic element 5 of FIG. 2J to the external surface of the cover layer 7) of, for example, 10 µm or more, preferably 50 µm or more, and for example, 500 µm or less, preferably 200 µm or less.

The cover layer 7 is formed, as described above, from a composition containing an inorganic substance.

The cover layer 7 preferably works as a heat dissipation layer and a reflection layer.

The cover layer 7 has a thermal conductivity of more than 0.20 W/m·K, preferably 1.0 W/m·K or more, more preferably 3.0 W/m·K or more, and for example, 30.0 W/m·K or less. The thermal conductivity can be determined by a xenon flash analyzer (manufactured by NETZSCH, LFA 447).

The cover layer 7 has a reflectivity of, for example, 80% or more, preferably 90% or more, and for example, 100% or less. The reflectivity can be determined by measuring reflection of light with a wavelength of 450 nm using an ultraviolet-visible spectrophotometer ("V 670", manufactured by JASCO Corporation).

The wavelength conversion member 1 can be used for, for example, semiconductor light-emitting devices (e.g., light-emitting diode device, semiconductor laser device) for far-reaching application including a high output light source such as lighting for vehicles, pendant lights, road lights, and stage lighting products.

To be specific, as shown in FIG. 4, the semiconductor light-emitting device 15 includes the light source 16 and the wavelength conversion heat dissipation member 17.

Examples of the light source 16 include a light-emitting diode (LED) and a semiconductor laser (LD).

The wavelength conversion heat dissipation member 17 is disposed to face the light source 16 in spaced-apart relation, and includes the wavelength conversion member 1 and the heat dissipation member 18.

The heat dissipation member 18 is provided on the surface (lower face) of the cover layer 7 of the wavelength conversion member 1. The heat dissipation member 18 is formed to be a generally rectangular flat plate shape when viewed from the top, and on the lower face thereof, a plurality of projections for improving heat-releasing characteristics are provided toward the lower side. The heat dissipation member 18 is, for example, a heat sink, and is formed from thermal conductive metals such as aluminum and copper, and a ceramic material such as AlN. The heat dissipation member 18 allows for heat dissipation of heat generated in the wavelength conversion member 1 to the outside.

The wavelength conversion heat dissipation member 17 is produced by, first, removing the release sheet 8a of the substrate-laminated wavelength conversion member 14, allowing the heat dissipation member 18 to adhere to the exposing surface of the cover layer 7 with a known thermal conductive adhesive layer (not shown), and then removing the substrate 4 from the cover layer 7 and the phosphor ceramic element 5 by, for example, heating.

In the wavelength conversion member 1, the phosphor layer is formed from the phosphor ceramic element 5, and therefore excellent heat resistance and heat-releasing characteristics can be achieved.

Furthermore, the cover layer 7 covering the phosphor ceramic element 5 contains inorganic substance, and therefore heat generated in the phosphor ceramic element 5 can be conducted efficiently to the outside through the cover layer 7, achieving excellent heat-releasing characteristics. Furthermore, the light diffused and radiated at the phosphor ceramic element 5 can be efficiently reflected.

In the method for producing a wavelength conversion member 1, the wavelength conversion member 1 including the phosphor ceramic element 5 separated into individual pieces and having excellent heat resistance, heat-releasing characteristics, and reflectivity can be produced easily and industrially.

### (Modified Example)

In the following Figures, for the members corresponding to the above-described members, the same reference numerals are given and detailed descriptions thereof are omitted.

In the embodiment of FIG. 1A to FIG. 1E, and FIG. 3, the portion of the phosphor ceramic layer 3 is scraped off using the dicing blade 10 to produce the element-disposed substrate 11 having a generally rectangular shape when viewed from the top; however, for example, as shown in FIG. 5A to FIG. 5D and FIG. 6, the element-disposed substrate 11 having a generally circular shape when viewed from the top can be produced by printing.

To be specific, first, as shown in FIG. 5A, the heat resistance substrate 21 is prepared.

The heat resistance substrate 21 is a substrate that is not deformed by a high temperature at the time of baking, and a known or commercially available one may be used.

Then, as shown in FIG. 5B, by printing such as screen printing, a green body 2a having a generally circular shape when viewed from the top and a generally rectangular shape when viewed in cross section is formed on the heat resistance substrate 21.

The composition composing the green body 2a is the above-described curable composition containing the inorganic substance.

Then, as shown in FIG. 5C, the green body 2a is baked. The plurality of phosphor ceramic elements 5 provided on the heat resistance substrate 21 is produced in this manner.

Then, as shown in FIG. 5D and FIG. 6, the phosphor ceramic element 5 is redisposed on the substrate 4. To be specific, the plurality of phosphor ceramic elements 5 are removed from the heat resistance substrate 21, and disposed on the substrate 4 in spaced-apart relation in width direction and front-back direction. The element-disposed substrate 11 is produced in this manner.

In the embodiment of FIG. 5A to FIG. 5D, the green body 2a is made by printing, and therefore the phosphor ceramic element 5 having a desired pattern such as a generally circular shape when viewed from the top and a generally rectangular shape when viewed from the top can be formed. Meanwhile, because the phosphor ceramic layer 3 does not have to be scraped off, the phosphor material yield can be improved.

Meanwhile, in the embodiment of FIG. 1A to FIG. 1E, the plurality of phosphor ceramic elements 5 are formed on the substrate 4, and therefore the plurality of phosphor ceramic elements 5 do not have to be redisposed. Therefore, the wavelength conversion member 1 can be produced efficiently and smoothly.

In FIG. 2I, the substrate 4, the cover layer 7, and the release sheet 8a are cut so as to include one phosphor ceramic element 5; however, the substrate 4, the cover layer 7, and the release sheet 8a can be cut so as to include, for example, two or more phosphor ceramic elements 5.

### [Examples]

In the following, the present invention is described in further detail with reference to Examples. However, the present invention is not limited to these. The specific numeral values such as mixing ratio (content), physical property values, and parameters used in the description below can be replaced with the upper limit value (numeral values defined with "or less", "less than") or the lower limit value (numeral values defined with "or more", "more than") of the corresponding mixing ratio (content), physical property values, parameters in the above-described "DESCRIPTION OF EMBODIMENTS".

A phosphor material powder composed of 11.34 g of yttrium oxide particles (purity 99.9%, manufactured by Nippon yttrium co., ltd.), 8.577 g of aluminum oxide particles (purity 99.9%, manufactured by Sumitomo Chemical Co., Ltd.), and 0.087 g of cerium oxide particles was prepared.

20 g of the phosphor material powder prepared was mixed with water soluble binder resin ("WB 4101", manufactured by Polymer Innovations, Inc.) so that the solid content volume ratio was 60: 40, and furthermore, distilled water was added. The mixture was put into an alumina-made vessel, zirconia balls having a diameter of 3 mm were added, and the mixture was subjected to wet blending with a ball mill for 24 hours, thereby preparing a slurry of phosphor material particles.

Then, the prepared slurry was tape-casted on a PET film 8 as a release sheet by doctor blade method and dried, thereby forming a green sheet 2 having a thickness of 75 µm (ref: FIG. 1A). Thereafter, the green sheet 2 was removed from the PET film 8, and the green sheet 2 was cut into a size of 20 mm × 20 mm. Two sheets of the green sheet 2 that was cut were prepared, and the two green sheets 2 were heat laminated using a hot press, thereby preparing the green sheet laminate 2.

Then, the prepared green sheet laminate 2 was heated in an electric muffle furnace in air at a temperature increase speed of 1 °C/min to 1200°C, and de-binder processing was performed, in which an organic component such as binder resin is decomposed and removed. Thereafter, the green sheet laminate 2 was transferred to a high temperature vacuum furnace, and heated under reduced pressure of about 10⁻³Torr (about 0.13Pa) and a temperature increase speed of 5°C/min to 1750°C. The baking was performed at that temperature for 3 hours, thereby producing a phosphor ceramic layer 3 (phosphor ceramic plate) having a thickness of 120 µm and composed of Y₃Al₅O₁₂: Ce (ref: FIG. 1B).

Then, the phosphor ceramic layer 3 was bonded to the pressure-sensitive adhesive layer side (upper face) of the thermal release sheet 4 (substrate, trade name "REVALPHA 31950", manufactured by Nitto Denko Corporation) set on the dicing frame of the dicing device (trade name "Dicing saw", manufactured by DISCO Corporation), thereby producing a ceramic laminate 9 (ref: FIG. 1C).

Then, the position in up-down direction of the dicing blade 10 (distal end width X: 0.4 mm) having a distal end with a generally rectangular shape when viewed in cross section was adjusted so that the distal end of the dicing blade 10 coincided with the upper face of the thermal release sheet 4.

Then, while rotating the dicing blade 10 at a high speed, the dicing blade 10 was moved relative to the ceramic laminate 9 so that the width direction interval (Y) and front-back direction interval were 3.0 mm, thereby scraping off a portion of the phosphor ceramic layer 3 into a grid-like form (ref: FIG. 1D).

In this manner, an element-disposed substrate 11 was produced. In the element-disposed substrate 11, the plurality of phosphor ceramic elements 5 (3.0 mm × 3.0 mm) were arranged in line in spaced-apart relation with an interval of 0.4 mm in front-back direction and width direction like a grid on the thermal release sheet 4 (ref: FIG. 1E and FIG. 3).

Then, a ceramic ink (trade name "RG 12-22", white, manufactured by AIN Co., Ltd.) was prepared as the material of the curable layer 6, and applied on a PET film 8a as the release sheet with a doctor blade, thereby forming a curable layer 6 having a thickness of 220 µm.

Then, the element-disposed substrate 11 is disposed to face the curable layer sheet 20 in spaced-apart relation in the thickness direction so that the phosphor ceramic element 5 faces the curable layer 6 (ref: FIG. 2F).

Then, the element-disposed substrate 11 is moved to the lower side, and pressed against the curable layer 6 with a pressure of 0.3MPa, thereby embedding the phosphor ceramic element 5 in the curable layer 6 (ref: FIG. 2G).

Then, after drying at 90°C for 5 hours, thermal curing was conducted at 150°C for 2 hours, thereby forming the cover layer 7. In this manner, the cover layer-element laminate 13 was produced (ref: FIG. 2H).

Then, the cover layer-element laminate 13 was disposed in the dicing device. Thereafter, using a narrow-width blade 19 (distal end width Z: 0.2 mm) having a distal end with a generally rectangular shape when viewed in cross section, the center in the width direction and the center in the front-back direction between the phosphor ceramic elements 5 were cut so as to penetrate the thermal release sheet 4, the cover layer 7, and the release sheet 8a in the thickness direction (ref: FIG. 2I). That is, the cover layer-element laminate 13 was cut to give a size of 3.2 mm × 3.2 mm. The phosphor ceramic elements 5 were separated into individual pieces, and a substrate-laminated wavelength conversion member 14 was produced in this manner.

Then, from the produced substrate-laminated wavelength conversion member 14, the PET film 8a was removed, and then the thermal release sheet 4 was removed at 200°C. In this manner, the wavelength conversion member 1 including one phosphor ceramic element 5 (3.0 mm × 3.0 mm, thickness 120 µm) and cover layer 7 (3.2 mm × 3.2 mm, side face width W: 0.1 mm, thickness T: 100 µm) was produced (ref: FIG. 2J).

While the illustrative embodiments of the present invention are provided in the above description, such is for illustrative purpose only and it is not to be construed as limiting in any manner. Modification and variation of the present invention which will be obvious to those skilled in the art are to be covered in the following claims.

### Industrial Applicability

The wavelength conversion member and production method thereof of the present invention can be applied to various industrial products, and for example, can be used for semiconductor light-emitting devices such as white light-emitting diode devices.

### [Description of reference numeral]

- 1: wavelength conversion member
- 3: phosphor ceramic layer
- 4: substrate
- 5: phosphor ceramic element
- 6: curable layer
- 7: cover layer
- 11: element-disposed substrate

## Claims

1. A method for producing a wavelength conversion member, the method comprising the steps of:
preparing an element-disposed substrate including a substrate, a plurality of phosphor ceramic elements disposed on the substrate in spaced-apart relation in a direction perpendicular to the thickness direction of the substrate,
embedding the plurality of phosphor ceramic elements in a curable layer containing the inorganic substance,
producing a cover layer by curing the curable layer, and
cutting the cover layer and the substrate in the thickness direction so as to include at least one of the phosphor ceramic elements.

2. The method for producing a wavelength conversion member according to Claim 1,
wherein the curable layer is formed from
a ceramic ink, or
a curable resin composition containing a curable resin and at least one inorganic particle of inorganic oxide particles and metal particles.

3. The method for producing a wavelength conversion member according to Claim 1, wherein the substrate is an easy-release sheet.

4. A wavelength conversion member produced by the method according to Claim 1.
